(19) Europäisches Patentamt

European Patent Office

Office européen des brevets

(11) EP 1 022 852 A2

(12) EUROPEAN PATENT APPLICATION

(43) Date of publication:
26.07.2000 Bulletin 2000/30

(51) Int Cl.⁷: H03H 9/02

(21) Application number: 00106913.7

(22) Date of filing: 20.12.1996

(84) Designated Contracting States:
AT BE CH DE DK ES FI FR GB GR IE IT LI LU MC NL PT SE
Designated Extension States:
AL LT LV RO SI

(30) Priority: 10.01.1996 RU 96100012

(62) Document number(s) of the earlier application(s) in accordance with Art. 76 EPC:
96946123.5 / 0 873 590

(71) Applicant: Sawtek, Inc.
Orlando, FL 32860-9501 (US)

(72) Inventors:
• Naumenko, Nataya F.
Moscow, 115589 (RU)
• Orlov, Victor S.
Moscow, 115589 (RU)

(74) Representative: Holmes, Miles Keeton et al
D. YOUNG & CO.,
21 New Fetter Lane
London EC4A 1DA (GB)

Remarks:
This application was filed on 31 - 03 - 2000 as a divisional application to the application mentioned under INID code 62.

(54) **High frequency saw device**

(57) A langasite crystal substrate having a prescribed range of Euler angles for substrate and crystal orientation improves signal processing for a surface acoustic wave (SAW) device, and thus for radiotelephones, mobile communication systems, television systems, and the like. When a voltage is applied to an input interdigital transducer IDT (2), a surface acoustic wave is generated in a piezoelectric substrate of langasite (1). This wave propagates in a direction generally perpendicular to electrodes of the IDT (2). The langasite crystal cut and wave propagation directions are defined which reduce insertion loss due to SAW transduction, diffraction, and beam steering. Temperature stability is improved. A low power flow angle and reduced level of diffraction is also achieved.

Fig.1

## Description

## Field of the Invention

The invention relates to a surface acoustic wave (SAW) device and, more particularly, to a device having a langasite crystal substrate with a predetermined crystalline orientation for causing a surface acoustic wave to propagate along a predetermined crystalline axis of the substrate.

## Background of the Invention

This invention relates to an optimal surface acoustic wave orientation on single crystal lanthanum gallium silicate or $La_3 Ga_5 Si O_{14}$, commonly known as langasite (LSG). SAW devices are currently used a bandpass filters, resonators, delay lines, convolvers, etc. in a broad range of RF and IF applications such as wireless, cellular communication and cable TV. Three commonly used substrates are lithium niobate, ST-quartz, and lithium tantalate. There are several material properties that determine the usefulness of any particular crystal and, in particular, orientation of a particular crystal. These properties include: 1) SAW velocity, Vs; 2) the SAW piezoelectric coupling coefficient, $k^2$; 3) the power flow angle, PFA; 4) the diffraction or beam spreading coefficient, $y$ (gama); and 5) the temperature coefficient of delay, TCD. It has not been possible to find an orientation in any existing substrate which optimizes these properties at the same time; so the choice of substrate and orientation depends upon what is important for the application, and almost always involves a compromise between the SAW material properties. A high velocity is desirable for high frequency devices, because the device geometry patters are larger and, therefore, the devices are easier to fabricate. At low frequencies, a low velocity is usually desirable because the device size is smaller, resulting in lower devices and packaging costs. Thus, there is no universally optimum velocity. For moderate to wide bandwidth devices, a high value of $k^2$ is desirable because it allows lower insertion loss. From the point of view of $k^2$, lithium niobate is best, quartz is worst, and lithium tantalate is in between. For most devices, and in particular narrow band devices, TCD should be as low as possible and ideally zero. From this point of view, ST-quartz is best, lithium niobate is worst, and lithium tantalate is in between (just the opposite ranking as for $k^2$). The optimum value of $y$ is -1, which results in minimum beam spreading. From this point of view, YZ lithium niobate is now ideal, ST-quartz is worst, and lithium tantalate is in between. The PFA should be zero, and this is the case for most of the commonly used SAW substrates, with an exception being 112° lithium tantalate, which has a PFA of 1.55°. For the most narrow band applications, ST-quartz is a quite acceptable choice; and for the very wide band applications where temperature stability is not so important (*e.g.,* a device can be held at constant temperatures), lithium niobate is usually quite acceptable. What is needed is a substrate orientation that offers the temperature stability of ST-quartz but with higher $k^2$ and at the same time low or zero beam steering (PFA) and diffraction ($y$ = -1). We have a substrate that meets these conditions.

A SAW device is known which contains a piezoelectric substrate with input and output interdigital transducers (IDT's) on its surface. ST quartz is used to achieve the better temperature stability. The orientation of ST-cut with respect to crystallographic axes is described by Euler angles $\phi = 0°$, $\theta = 132.75°$, and $\psi = 0°$. For this cut, the temperature coefficient is equal to zero.

The known device has a disadvantage of high insertion loss due to transduction loss because of a low electromechanical coefficient $k_s^2 = 0.116\%$, and propagation loss in high frequency range (more than 3.1 Db/$\mu$s at frequency 1 GHz). This results in an increased insertion loss of devices and makes it impossible to use them in mobile communication systems. The insertion loss of filters for mobile communications must not exceed 3-4 Db at intermediate radio-frequencies 800-1800 MHZ.

## SUMMARY OF THE INVENTION

It is the object of this invention to provide a langasite crystal having a substantially planar surface defined by the Euler angles, such that SAW propagation within this range of angles on langasite is characterized by piezoelectric coupling about two to three times stronger than typically found with ST-quartz, by way of example, near zero PFA, near zero TCD, and near minimum beam spreading. While the latter three conditions cannot all be met exactly for any orientation, the performance as measured just by these three conditions together is significantly better than-any known cut of Li Nb O$_3$, Li Ta O$_3$, or quartz, and choices within this range can be chosen to favor one or two at the slight expense of the third.

A preferred embodiment of the present invention includes a device which contains a langasite substrate (1) on the surface of which input and output IDT's are placed.

The use of the langasite offers a decreased propagation loss as compared to quartz (up to 1 dB/$\mu$s at the frequency 1 GHZ). To reduce the transduction loss, the Euler angles, which define the orientation of the substrate, are chosen as follows: $\phi = 90°$, $\theta = 10°$, and $\psi = 0°$.

The following disadvantages in the known devices include bad temperature stability (the temperature coefficient = 12 10$^{-6}$) and high transduction loss, high beam steering loss, and high diffraction loss, defined by electromechanical coupling $k_s^2$, PFA $\phi$ and anisotropy parameter, respectively. For the mentioned device, $k_s^2$ = 0.25%, $\phi$ = -5.7%, and $y$ = -2.859%.

The present invention is directed toward reducing insertion loss and improving temperature stability.

This purpose is achieved as follows: the surface of the langasite substrate is perpendicular to axis Z, electrodes of IDT's are perpendicular to axis X and are parallel to axis Y. Axes X, Y, Z are defined by Euler angles with respect to crystallographic axes X, Y, Z of langasite - angle $\phi$ is in the range -15° to 10°, angle $\theta$ in the range of 120° to 165°, and angle $\psi$ in the range of 20° to 45°.

## BRIEF DESCRIPTION OF THE DRAWINGS

FIG. 1 diagrammatically illustrates substrate axes X', Y', and Z' and crystal axes X, Y, and Z along with Euler angles describing relative orientation of X,Y, and Z to X', Y', and Z';

FIG. 2 is a perspective view of a SAW device illustrating interdigital transducers located on a langasite substrate surface;

FIG. 3 illustrates SAW parameters (Velocity, Power Flow Angle, Electromechanical Coupling Coefficient, and Temperature Coefficient) versus propagation angle $\psi$ for different values of $\theta$; and

FIG. 4 illustrates SAW parameters of FIG. 3 versus $\psi$ for $\theta$=145° for different values of $\phi$.

## DESCRIPTION OF THE PREFERRED EMBODIMENT

The crystal cut of langasite with Euler angles $\phi$ = -1%, $\theta$= 135.6° +/- 10%, and $\psi$ = 24.1° +/- 8°, provide improved performance for SAW devices. Specifically, the crystal cut provides a near simultaneous optimization of three critical SAW propagation parameters and a favorably value of a fourth parameter. This fourth parameter is the coupling constant $k^2$, which varies between 0.25 and 0.35% as compared to .12% for ST-quartz crystal. The three SAW propagation parameters are PFA, *y* and TCD, which are the power flow angle, the diffraction coefficient, and the temperature coefficient delay, respectively. PFA is also known as the beam steering angle and is the angle between the SAW wave vector, which is always normal to the tap electrodes, and the direction of the power flow. Ideally, PFA should be zero. *y* is a measure of the diffraction or beam spreading. Normally, as a SAW propagates on a substrate, the beam profile will change and broaden. This beam spread causes diffraction loss and distortion to the filter response. For isotropic materials, the value of *y* is zero, and diffraction is a moderately serious problem. Diffraction is minimized when *y* = -1, and this is the case for YZ Li Nb $O_3$ and a special MDC (minimum diffraction cut) of Li Ta $O_3$. For ST-quartz, *y* = +.38, and diffraction is worse than the isotropic case. There is a range of angle within the designated range of this disclosure for which *y* = -1, which is ideal. Likewise there is a range of angles for which the TCD is zero. (TCD is the relative change in delay per degree centigrade.) The ideal parameter values are obtained for each parameter within the restricted range of angles of this disclosure; but since the angles associated with the values form a locus of points in a two-dimensional angle space (over $\theta$ and $\psi$), there is no point at which the three loci intersect. That means it is possible to achieve ideal performance in two of the three parameters but not all three parameters. Therefore, within this range, the optimal choice of angles would still be dependent upon the application, and in fact are intermediate points that minimize the problem of all three parameters. This is the reason for the spread of angles in this disclosure.

There sometimes is confusion about the use of Euler angles so a verbal description is appropriate.

Consider a wafer outline on a surface normal parallel to the axis Z'. Now construct a flat along' one edge of the wafer one normal to the axis X'. The direction of SAW propagation is parallel to axis X'. Now assume that the crystal axes X, Y, Z are coincident with the wafer outline axes X', Y', Z', respectively. With no rotation, the wafer is considered Z cut (the wafer is cut with the polished surface normal to Z) and X propagating (the SAW propagates in a direction parallel to the X axis). With any subsequent rotation, the wafer axes X', Y', Z' are rotated, and the crystal aces X, Y, Z are assumed to be fixed. Now, by way of example, consider the Euler angles ($\phi$, $\theta$, $\psi$) = (0°, 135°, 28°), which is a case near the middle of the designated range. The first rotation would rotate around Z' (X' toward Y') by $\phi$. Since $\phi$ = 0°, there is no rotation for this case. The next rotation is around the "new" X' (the "new" axes are always tied to the wafer so that any rotation is around a wafer axis that includes all previous rotations) by $\theta$ (which is 135°) (Y' toward Z' for a positive angle rotation). Finally, rotate around Z' (X' toward Y') by $\mu$, which in this case is 28°.

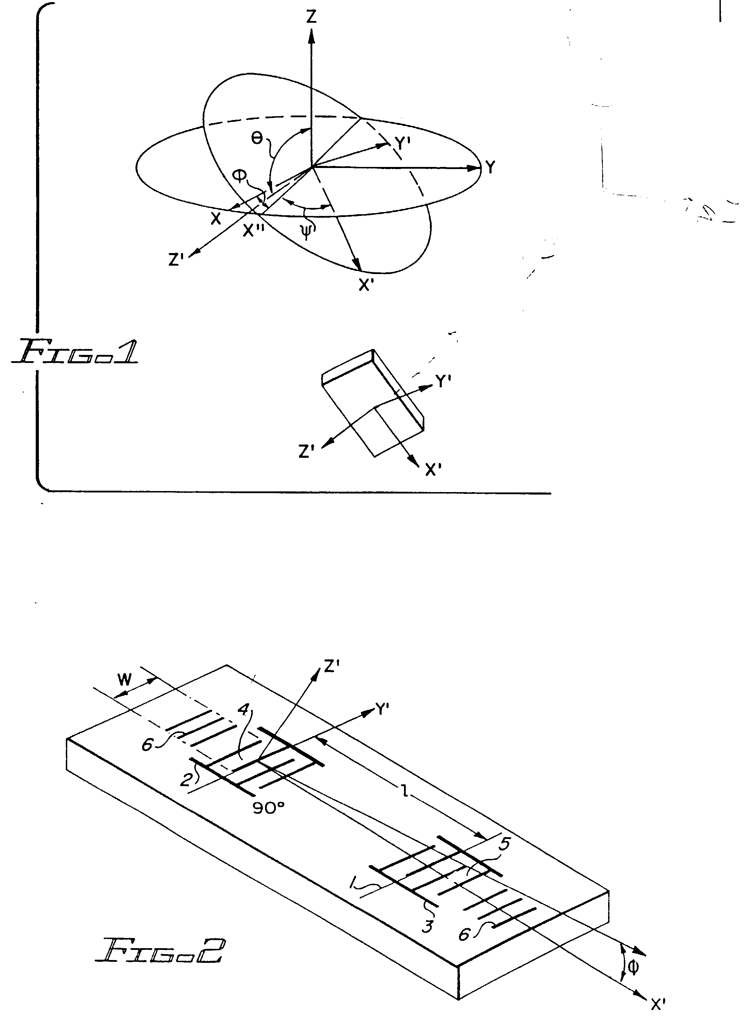

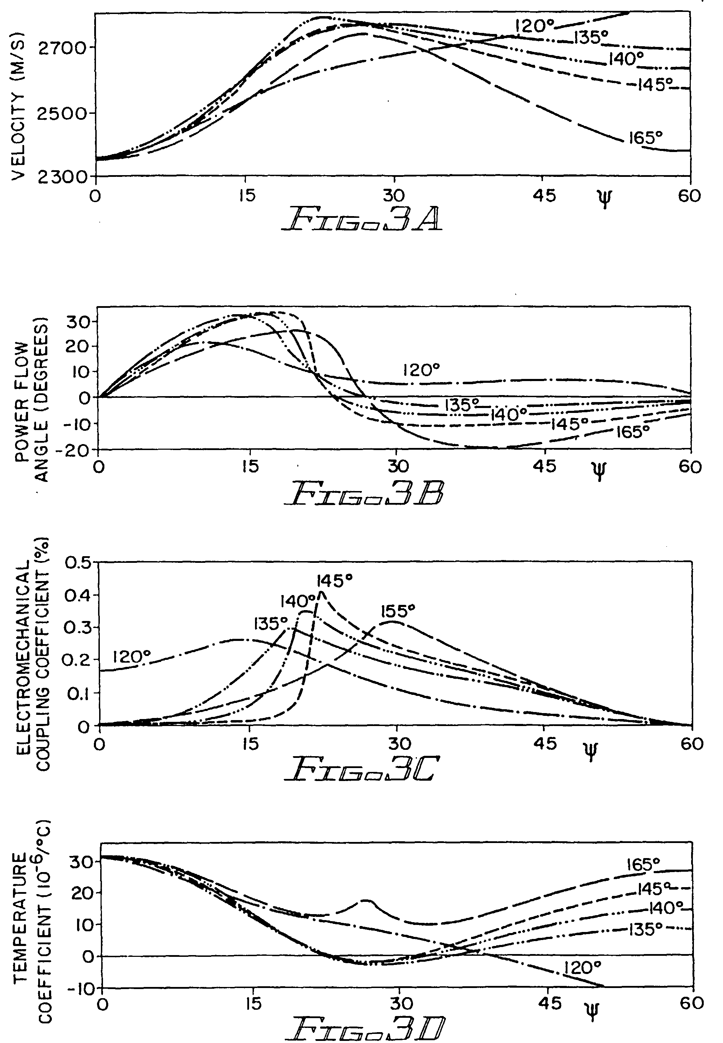

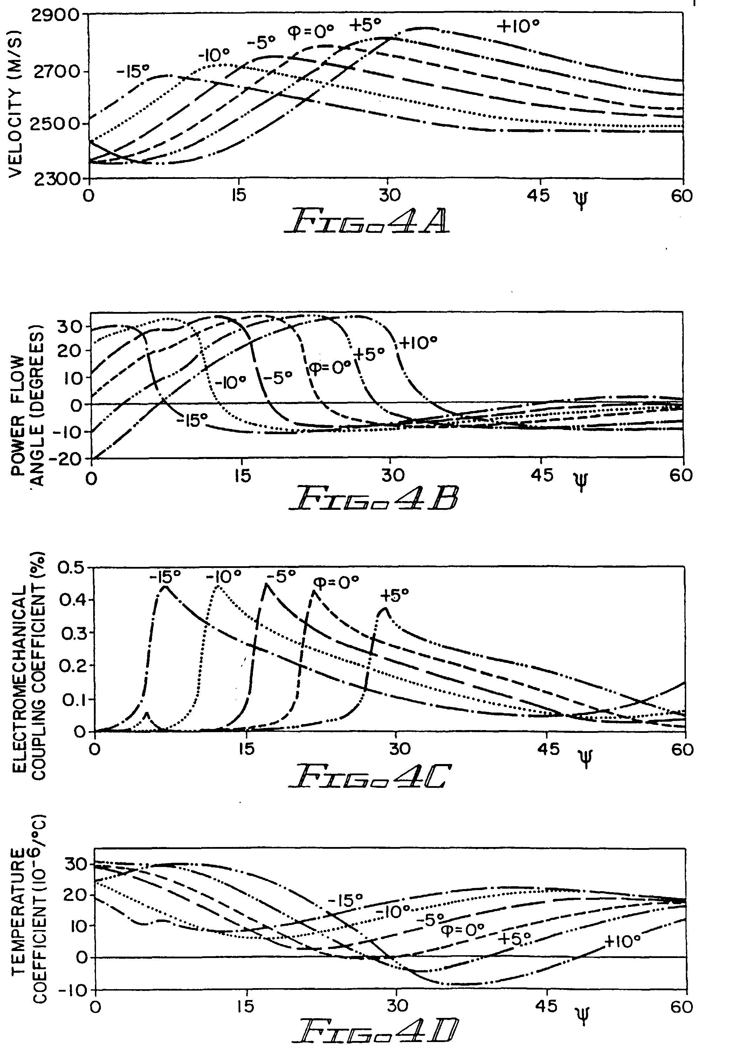

A high frequency SAW device is described with reference to FIGS. 1 and 2. FIG. 3 illustrates SAW velocity, PFA $\phi$, electromechanical coupling $k_s^2$ and temperature coefficient versus Euler angle $\psi$ for some values of angle $\theta$ and for $\phi$ = 0°. Velocity, $\phi$, $k_3$ and temperature coefficient versus $\psi$ for some value of $\phi$ and for $\theta$ = 145° are illustrated in FIG. 4.

A preferred embodiment of the present invention includes a SAW device containing a langasite substrate (1), and IDT's (2), (3) and reflecting electrodes (6), if necessary. The normal Z' to the substrate surface, the normal X' to electrodes 4, 5, 6, by way of the example illustrated, and axis Y' (parallel to electrodes) are defined with respect to crystallographic axes as follows: $\phi$ = -15° to 10°; $\theta$ = = 120° to 165°, $\psi$ = 20° to 45°, where $\phi$, $\theta$, $\psi$ are Euler angles.

$\phi$ is the angle between crystallographic axis X and auxiliary axis X", which is the axis of rotation of the plane XY (up to required orientation of the substrate surface).

$\theta$ is the angle between axis Z and the normal Z' to the substrate surface (1).

$\psi$ is the angle between axis X" and axis X', X' is perpendicular to electrodes of IDT's (2), (3).

The SAW device operates as follows. When a voltage is applied to IDT (2), the surface acoustic wave is generated in the substrate and the energy flow propagates in the direction X' (the angle between X" and X' is equal to $\phi$). SAW is detected by the output IDT and converted into the output voltage. The insertion loss of the SAW device results from a number of factors (bidirectionality is not considered here): transduction loss $a_t$ = $a_{t1}$ + $a_{t2}$ of the input and output IDT, defined by the electromechanical coupling propagation loss $a_p$ in the substrate, diffraction loss $a_d$, beam steering loss $a_o$.

Therefore the insertion loss is defined as follows:

$$a_L = a_{T1} + a_{T2} + a_p + a_d + a_0, dB$$

Each component of the insertion loss depends on electrophysic parameters of the substrate and the geometric parameters of IDT's.

The transduction insertion loss $a_{Ti}$ is inverse to the electromechanical coupling coefficient for an IDT with N pairs of electrodes matched by an inductor at the central frequency:

$$a_{Ti} = -10 \lg [2b/(1 + b)^2], dB$$

where b = $G_0/G_a$; $G_0$ - load conductance; $G_a$ - IDT admittance. For example, the admittance of an unapodized IDT at the central frequency $f_0$ is defined as:

$$G_a = 8 k_s^2 f_0 C_s N^2 W$$

where $C_s = 2 (\varepsilon^T_{pr} + 1) (6.5) d_n^2 + 1.08 d_n + 2.37) 10^{-12}$; F/m - capacitance of an electrode pair of unit length; $\varepsilon^T_{pr}$ - dialectic permitivity; W - aperture; N - number of electrode pairs, which is defined by the specified band width as follows: N = 0.632 $(\Delta f_{-3}/f_0)$, where $(\Delta f_{-3})$ normalized 3dB-bandwidth.

The propagation loss is proportional to the distance between input and output IDT:

$$a_p = bf^2 + df, dB/\mu sec,$$

where b,c - constants of the substrate material; f - operating frequency, GHz.

The beam steering loss is proportional to angle :

$$a_0 = -20 \lg (1 - B \, tg \, \phi), dB$$

where B-geometrical parameter, which is equal to I/w; I-distance between IDT centers; W - aperture.

The diffraction loss in the Fresnel region is defined as follows [4]:

$$a_d = -10 \lg [\int_{-1/2}^{+1/2} u(W,y) \, dy], dB$$

where

$$Re \, u(W,y) = Ci(\alpha_1) - Ci(\alpha_2),$$

$$Im \, u(W,y) - Si(\alpha_2) - Si(\alpha_1),$$

$$a_1 = \pi W^2 (y + 1/2)^2/[ \mid 1+y \mid 1\lambda],$$

$$a_2 = \pi w^2 (y - 1/2)^2/[ \mid 1+y \mid 1\lambda],$$

$C_i(\alpha)$ and $S_i(\alpha)$ Fresnel integrals; $y$ - anisotropy parameter of the substrate material in the propagation direction; $\lambda$ - wavelength. Diffraction loss depends on the sign and value of $y$ and is minimum if $y$ = -1, which corresponds to cuts with auto-collimation.

Thus, the insertion loss in a device can be reduced by choosing an orientation of a substrate with high electromechanical coupling, low beam steering angle $\phi$, anistropy parameter (close to -1). For typical value for IDT aperture, W = (20-80)$\lambda$ and the distance between input and output transducers I = (200-300)$\lambda$, the diffraction loss is related to the distortion of the form of acoustic beam and does not exceed 1.6 dB [1]. Therefore the insertion loss of the device mostly depends on transduction loss and beam steering loss.

Let us estimate advantages of the proposed device as compared to the known on [2].

The SAW propagation parameters of the device-prototype with orientation (90°, 10°, 0°) are as follows: temperature coefficient = 12 $10^{-6}(1/°C)$, $k_s^2$ = 0.26%, $\phi$ = -5.7°.

As it is shown in FIGS. 3 and 4 in the proposed device based on langasite for any Euler angles within chosen limits 15° $\phi \le$ +10°, 120° $\le \theta \le$ 165°, 20° $\le\psi\le45°$, the temperature coefficient does not exceed 10 $10^{-6}(1/°^{\wedge}C$ and for orientation (0°, 144°, 22,75°) it is close to zero.

As a consequence, the temperature stability is improved as compared to the known device.

It is shown in FIGS. 3 and 4 that in the proposed device, the PFA $\phi$ is less than 5° and the electromechanical coupling coefficient is more than 0.2% with the maximum value 0.45%. Consequently on the most part of the proposed orientations, the electromechanical

coupling coefficient $k_s$ is more than that in the device and the angle $\phi$ is less than that of the device. This results in the decreased transduction and beam steering loss. In some cases for $80° \leq \psi \leq 45°$, $k_s^2$ is somewhat less than that of the prototype ($0.2\% < k_s^2 < 0.26\%$) which is compensated by decreasing beam steering loss.

Therefore for any value of each Euler angle within the proposed group of orientation it is always possible to find such values of two other angles that their combination provides the improved temperature and stability and the decreased insertion loss as compared to the prototype.

Therefore, the desired result is achieved in the proposed device.

Consider, by way of example, a filter for wireless radiotelephones (European standard DECT) for intermediate frequency $f_0$ = 110.6 Mhz with a bandwidth $\Delta f_{0-3}$ = 0.965 Mhz or $(\Delta f_{-3}/f_0)$ = 0.88%. The langasite substrate is used with orientation defined by Euler angles ($0°, 146°, 22.5°$) and the following parameters: $k_s^2$ = 0.42%, $\phi$- 0.9°, temperature coefficient = 2 $10^{-6}$ (1/°C). With the number of electrodes of each IDT close to the optimal value N = 72 (which provides minimum transduction loss if the load resistance is 50 ohms, aperture W = 3.5 and the distance between IDT's I = 10mm), the transduction loss of the proposed device is near zero (bidirectionality is not considered) and the beam steering loss is 0.4 dB.

For a device with similar geometric parameters, the values of transduction and beam steering loss are 0.6 dB and 2.9 dB, respectively. Then the gain in the insertion loss is 3.1 dB. Furthermore, the temperature stability is considerably better than that of the prototype.

By way of further example, consider a high frequency filter for the selection of carrier radio-frequencies in wireless radiotelephones (European standard DECT). The operating frequency is $f_0$ = 1,89 GHz, the bandwidth $\Delta f_{-3}$ = 20 MHz or $(\Delta f_{-3}/f_0) \approx$ 1%. For N = 65, a typical aperture W = 0.14 mm (100λ) the distance between IDT's centers I = 1mm and the substrate orientation defined by Euler angles ($0°, 144°, 22.75°$) with parameters: $k_s^2$ = 0.37, $\phi \approx 0°$, temperature coefficient $\approx 0$ (1/°C), the beam steering loss is zero and the transduction loss is 1.2 dB (the bidirectionality is not considered).

For the device with similar geometric parameters, the beam steering and transduction loss are 2.6 dB and 10.8 dB, respectively. The gain in the insertion loss is 12.2 dB. Moreover, the temperature stability is improved.

It is worth noting that earlier mentioned low-loss filters cannot be designed based on ST quartz.

While specific embodiments of the invention have been described in detail herein above, it is to be understood that various modifications may be made from the specific details described herein without departing from the spirit and scope of the invention as set forth in the appended claims.

Having now described the invention, the construction, the operation and use of preferred embodiments thereof, and the advantageous new and useful results obtained thereby, the new and useful constructions, methods of use and reasonable mechanical equivalents thereof obvious to those skilled in the art, are set forth in the appended claims.

## Claims

1. A surface acoustic wave (SAW) device comprising:

   a langasite substrate having a SAW propagation surface;
   input and output interdigital transducers having electrodes on the surface for launching and detecting surface acoustic waves, wherein a surface wave direction of propagation is along an X' axis, the substrate further having an Z' axis normal to the surface, and a Y' axis along the surface and perpendicular to the X' axis, the langasite substrate further having a crystal orientation defined by crystal axes X,Y, and Z, the relative orientation of device axes X', Y', and Z' being defined by Euler angles $\phi$, $\Theta$, and $\psi$; and wherein $\phi$ has a value ranging from -15° to 10°, $\theta$ has a value ranging from 120° to 165°, and $\psi$ has a value ranging from 20° to 45°.

Z

θ

Φ

X

X"

Z'

ψ

Y'

Y

X'

Y'

Z'

X'

*FIG-1*

W

Z'

4

6

Y'

2

1

90°

5

3

6

φ

X'

*FIG-2*

FIG-3A

FIG-3B

FIG-3C

FIG-3D

Fig. 4A

Fig. 4B

Fig. 4C

Fig. 4D